# FASCICULE DE BREVET EUROPEEN

(11) **EP 0 751 556 B1**
(45) Date de publication et mention de la délivrance du brevet: **01.10.2003**
(21) Numéro de dépôt: 96401425.2
(22) Date de dépôt: 27.06.1996
(51) Int. Cl.: H01L 21/48, H01L 21/68

(54) **Procédé de réalisation d'un substrat d'interconnexion permettant de connecter une puce sur un substrat de réception**
Herstellungsverfahren eines Verdrahtungssubstrates zur Verbindung eines Chips zu einem Träger
Fabrication process for an interconnection substrate allowing to connect a die to a carrier substrate

(30) Priorité: 30.06.1995 FR 9507920
(43) Date de publication de la demande: 02.01.1997
(73) Titulaire: COMMISSARIAT A L'ENERGIE ATOMIQUE, 75015 Paris (FR)
(72) Inventeur: Caillat, Patrice, 38130 Echirolles (FR); Henry, David, 38100 Grenoble (FR)
(74) Mandataire: Poulin, Gérard

(56) Documents cités:
- EP-A- 0 560 077
- DE-A- 4 203 114
- US-A- 5 258 236
- IBM TECHNICAL DISCLOSURE BULLETIN, vol. 36, no. 06b, Juin 1993, NEW YORK US, pages 173-174, XP002010756 "Planarized Testing Pads for Thin Films in Serial Parallel Process"

## Description

### Domaine technique

La présente invention se rapporte à un procédé de réalisation d'un substrat d'interconnexion permettant de connecter une puce sur un substrat de réception.

Les substrats d'interconnexion servent d'intermédiaire pour le montage d'une ou de plusieurs puces électroniques sur un support tel que, par exemple, les cartes de circuits imprimés. Leur fonction essentielle est d'adapter le pas très serré des entrées et sorties des puces avec le pas beaucoup plus espacé de bornes de connexion réalisées sur les cartes de circuits imprimés.

L'invention s'applique donc en particulier dans les domaines de l'électronique où des puces à forte intégration sont associées à des circuits imprimés classiques.

### Etat de la technique antérieure

Comme indiqué ci-dessus, la fonction essentielle des substrats d'interconnexion est d'adapter le pas de bornes de connexion du substrat de réception ou pas très fin des entrées et sorties des puces. Une autre fonction, très importante également, est celle d'absorber les contraintes mécaniques survenant entre la puce et le substrat de réception. Ces contraintes proviennent essentiellement de différences de dilatation thermo-mécaniques entre les puces et le circuit imprimé.

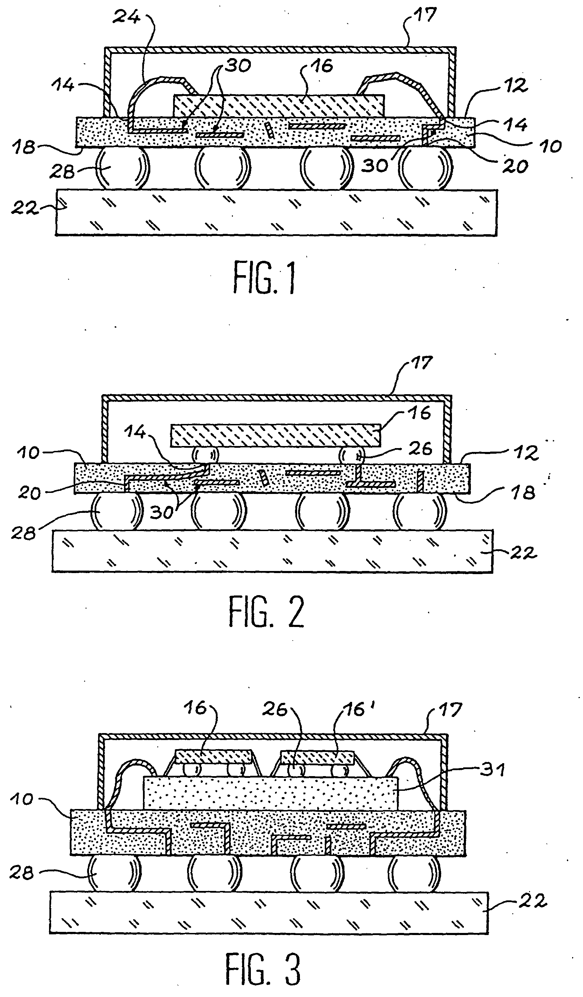

Comme le montrent en coupe les figures 1 et 2, les substrats d'interconnexion 10 comportent respectivement une face 12 avec des bornes d'entrée 14 connectés à une ou plusieurs puces 16 et une face 18, opposée à la face 12 avec des bornes de sortie 20 connectés à un substrat de réception 22. La puce 16 peut être reliée aux bornes d'entrée 14 soit par des liaisons par fil 24 encore connues sous la désignation "wire-bonding" (figure 1), soit par des microbilles fusibles 26 selon une technique connue sous la désignation de "Flip-Chip" (figure 2). La puce 16 est avantageusement protégée par un capot 17.

Les substrats d'interconnexion 10 sont montés sur le substrat de réception 22 par des billes de matériau fusible 28 qui relient les bornes de sortie 20 à des pistes conductrices du substrat de réception non représentées sur les figures.

Les billes de matériau fusibles 28 reliant le substrat d'interconnexion au substrat de réception sont plus grosses en général que les microbilles 26 qui relient les puces au substrat d'interconnexion. Pour éviter toute confusion, les billes fusibles 28 sont donc désignées par "macrobilles" dans la suite de la description. Elles ont typiquement un diamètre de l'ordre de 200 à 800µm.

Ces macrobilles remplacent avantageusement d'autres types de liaisons telles que des liaisons par broches. Elles permettent en effet de mieux encaisser les contraintes de dilatation différentielles entre les puces et le substrat de réception et donc de réduire les contraintes exercées sur les puces.

La liaison par macrobilles des substrats d'interconnexion sur des substrats de support est connue sous la dénomination BGA ("Ball Grid Array"). On peut se reporter à ce sujet au document (1) référencé à la fin de la présente description.

Le document (1) indique également les différents types de substrat d'interconnexion et de macrobilles utilisées pour une interconnexion BGA.

De façon générale, le substrat d'interconnexion est à base de bismaléide-triazine (BT) ou en verre époxy. Toutefois, on distingue la BGA sur substrat d'interconnexion rigide de la BGA sur circuit souple.

Les substrats d'interconnexion rigides présentent une structure multicouches formée par sérigraphie sur une plaque rigide d'époxy et de fibre de verre par exemple.

Dans une telle structure, les bornes d'entrée sont reliés aux bornes de sortie par l'intermédiaire de trous métallisés et éventuellement de niveaux métalliques intermédiaires pratiqués dans le substrat d'interconnexion. On entend par trous métallisés des trous réalisés le plus souvent mécaniquement qui sont métallisés pour permettre un contact électrique entre la face avant et la face arrière ou entre deux niveaux métalliques.

Sur les figures 1 et 2, les trous métallisés et les niveaux métalliques intermédiaires sont repérés avec la référence 30. Comme ces figures sont des coupes transversales, et que toutes les bornes ne sont pas nécessairement disposées dans le plan de coupe, certains trous métallisés n'apparaissent que partiellement.

Les substrats d'interconnexion connus font appel, pour la plupart, à des techniques de fabrication également connues telles que la sérigraphie et la croissance électrolytique.

On connaît également des substrats rigides formés d'une structure de céramique multicouche obtenue par pressage à chaud. Une telle structure est montrée par exemple à la page 12 du document (1).

Le document DE-A-4 203 114 décrit un procédé correspondent au préambule de la revendication 1, la couche de détachement étant dissoute par un solvant.

Aux pages 65 et 66 du document (1), est décrite une technique de BGA sur circuit souple. Le circuit souple qui forme le substrat d'interconnexion présente une structure de type cuivre-polyimide-cuivre comparable à celle utilisée dans les techniques de TAB (Tape Automatic Bonding) utilisant comme isolant une couche de matériau commercialisé sous le nom Kapton, et des films conducteurs en cuivre sérigraphiés sur une ou les deux faces du circuit souple, la connexion entre les deux faces étant alors réalisée par des trous métallisés.

Après l'assemblage des puces sur une bande de circuit souple et la mise en boîtier de ces puces, la bande est découpée, équipée de macrobilles puis reportée sur un circuit imprimé de réception.

Finalement, quelle que soit la structure de substrat intermédiaire utilisée, sa fabrication met en jeu des techniques de sérigraphie, de laminage et de trous métallisés. La réalisation de trous métallisés est en effet la seule possibilité connue pour faire passer les signaux, traités par les puces, des bornes d'entrée vers les bornes de sortie.

Les substrats d'interconnexion connus présentent ainsi des performances médiocres pour la transmission de signaux de fréquence élevée des puces vers le substrat de réception, ou entre les puces.

En effet, on peut noter que les puces (ou circuits intégrés) utilisent des pistes métalliques, généralement en aluminium avec une épaisseur de l'ordre de 1µm. Ces pistes, formant des lignes de transmission, sont isolées, par exemple avec un isolant minéral de même épaisseur. Les propriétés électriques de transmission de telles lignes permettent le transport de signaux de haute- fréquence sur une longueur maximale de 15 mm.

Les circuits intégrés sont donc conçus de façon à ne guère dépasser 15 mm de côté. Toutefois, les substrats d'interconnexion qui doivent relier entre eux une pluralité de puces posent des problèmes de limitation en fréquence. Pour améliorer leurs performances électriques il est donc nécessaire de réduire la résistivité de leurs pistes conductrices. La réduction de la résistivité nécessite une augmentation de l'épaisseur des pistes métalliques mais aussi de l'épaisseur du matériau diélectrique séparant les niveaux conducteurs. Ceci peut être fait avec les techniques usuelles de circuit imprimé, de céramique multicouche co-frittée ou des techniques de circuit souple, en augmentant l'épaisseur des couches isolantes de polyimide (10µm). Cependant, de telles mesures entraînent des limitations de la résolution du pas entre les bornes et de la densité d'entrée et de sortie des puces, ce qui va à l'encontre de la fonction première des substrats d'interconnexion.

Ainsi, pour les substrats d'interconnexion destinés à accueillir une pluralité de puces, désignés communément par substrat d'interconnexion MCM (Multi-Chip-Module), on a recours à un substrat d'interconnexion intermédiaire supplémentaire.

La figure 3 donne un exemple d'une structure de type MCM. Cette structure comporte, de même que les structures représentées aux figures 1 et 2, un substrat de réception 22 équipé de macrobilles 28. Cependant, plusieurs puces 16, 16' devant être connectées non seulement au substrat de réception 22 mais aussi entre elles, ne sont pas directement reliées au substrat d'interconnexion 10 mais sont reliées à un substrat d'interconnexion intermédiaire supplémentaire 31.

Le substrat d'interconnexion intermédiaire 31 est réalisé sur une plaque de silicium et comporte de trois à cinq niveaux conducteurs en cuivre séparés par des couches isolantes épaisses en polyimide. Le substrat intermédiaire a pour rôle de permettre les échanges de signaux rapides, c'est-à-dire de haute fréquence, entre les puces et des puces vers le substrat d'interconnexion 10.

Un substrat d'interconnexion intermédiaire 31, même s'il apporte une solution à l'interconnexion rapide d'une pluralité de puces, constitue un élément supplémentaire coûteux dans le report des puces sur le substrat de réception. Il nécessite aussi trois opérations d'interconnexion : une interconnexion des puces sur le substrat intermédiaire supplémentaire, une interconnexion du substrat intermédiaire sur le substrat d'interconnexion, puis un report du substrat d'interconnexion sur le substrat de réception. Ceci augmente le temps et le coût de l'opération.

On connaît également des structures de type MCM à film mince. ces structures sont décrites, par exemple, dans le document (2) référencé à la fin de la présente description.

Un but de la présente invention est de proposer un procédé de réalisation d'un substrat d'interconnexion ne présentant pas les limitations évoquées ci-dessus.

Un autre but de la présente invention est de proposer un procédé de réalisation d'un substrat d'interconnexion autorisant l'interconnexion d'une pluralité de puces sur un substrat de réception et capable de transmettre des signaux de haute fréquence. On entend par signaux de haute fréquence des signaux ayant une fréquence supérieure à 50 MHz.

### Exposé de l'invention

Pour atteindre ces buts, l'invention a plus précisément pour objet un procédé de réalisation d'un substrat d'interconnexion permettant de connecter au moins une puce électronique sur un substrat de réception, le substrat d'interconnexion présentant une première face avec des bornes d'entrée aptes à être connectés à la puce et une deuxième face, opposée à la première face, présentant des bornes de sortie aptes à être connectés au substrat de réception, caractérisé en ce que le procédé comporte les étapes suivantes :
a) - formation sur un substrat dit initial, d'une couche de matériau fusible,
b) - formation d'une première couche de matériau diélectrique et gravure de cette couche pour y pratiquer des ouvertures correspondant aux bornes de sortie du substrat d'interconnexion,
c) - formation de pavés de métal respectivement dans les ouvertures, les pavés formant les bornes de sortie,
d) - dépôt d'une couche de métal recouvrant les pavés de métal,
e) - gravure de la couche de métal pour former des pistes conductrices, les pistes se superposant, au moins en partie aux ouvertures pratiquées dans la couche de matériau diélectrique située sous la couche de métal formée lors de l'étape d),
f) - formation d'une couche de matériau diélectrique recouvrant les pistes conductrices et gravure de cette couche pour y former des ouvertures se superposant au moins en partie, aux pistes conductrices formées lors de l'étape e),
g) - formation de pavés de métal dans les ouvertures pratiquées dans la couche de matériau diélectrique lors de l'étape f),
h) - séparation du substrat d'interconnexion d'avec le substrat initial par chauffage du matériau fusible à une température supérieure ou égale à sa température de fusion.

Selon un aspect de l'invention le procédé de l'invention peut comporter en outre entre les étages g) et h), une étape de formation de plots d'accrochage respectivement sur les pavés de métal formés lors de l'étape g), les plots d'accrochage formant les bornes d'entrée.

Dans le cadre de la présente invention, on entend par matériau fusible un matériau présentant une température de fusion suffisamment basse pour ne pas endommager le substrat d'interconnexion et/ou les puces lors de cette opération de décollement. A titre d'exemple, la température de fusion peut être comprise entre 100°C et 350°C.

Le matériau fusible peut être soit un métal tel qu'un alliage à base d'étain et de plomb, soit un polymère thermoplastique.

Selon un aspect de l'invention, lors de l'étape c) les pavés peuvent être formés par électrolyse, en utilisant la couche de matériau fusible comme électrode, dans ce cas, le matériau fusible doit être conducteur. La couche de matériau fusible conducteur électrique a alors un rôle double. Elle constitue, d'une part, une prise de contact électrique pour assurer la croissance électrolytique des pavés de métal dans le premier masque de matériau diélectrique, une formation de ces pavés par la voie de l'électrolyse étant pour des raisons de coût, préférable à une pulvérisation cathodique. D'autre part, la couche de matériau fusible autorise un décollement aisé du substrat d'interconnexion d'avec le substrat initial en chauffant l'ensemble de la structure à une température supérieure à la température de fusion du matériau fusible. Lorsque le matériau fusible n'est pas conducteur, les pavés métalliques sont formés par pulvérisation cathodique ou évaporation sous vide.

Les pistes conductrices et les ouvertures pratiquées dans les couches de matériau diélectrique sont gravées selon des motifs choisis convenablement pour relier les bornes d'entrée présentant un pas, faible, aux bornes de sortie avec un pas plus important. On entend par pas des bornes l'espacement moyen entre deux bornes voisines. Lorsque la différence de pas entre les bornes d'entrée et de sortie est importante où lorsque la complexité de l'interconnexion entre puces le requiert les étapes d), e), f) et g) du procédé peuvent être répétés plusieurs fois. A titre d'exemple, lorsqu'on souhaite connecter une puce avec 500 entrées/sorties, ou plus, un seul niveau de métal ne suffit pas.

Le substrat d'interconnexion se présente alors commet un empilement alterné de plusieurs couches de matériau diélectrique et de pistes conductrices.

Selon un aspect particulier de l'invention, lors de l'étape g) ou des étapes g) répétées, les pavés de métal sont formés par électrolyse en utilisant la couche de matériau fusible, les pavés et les pistes conductrices comme électrodes quand le matériau fusible est un conducteur électrique.

Selon un autre aspect de l'invention, la ou les puces à reporter peuvent être montées sur le substrat d'interconnexion juste avant l'étape h) du procédé.

Par ailleurs, dans un procédé de réalisation collectif et simultané d'un grand nombre de substrats d'interconnexion élémentaires, celui-ci peut comporter une étape supplémentaire de découpage du substrat d'interconnexion et/ou de la (des) puce(s) en des parties élémentaires.

Après l'étape h) du procédé, il est possible aussi de mettre en place sur les bornes de sortie des plots d'accrochage et des billes de matériau fusible. Dans le cas où le matériau fusible est électriquement conducteur, lors du décollement du substrat d'interconnexion, les pavés conducteurs restent recouverts par du matériau fusible qui peut former ainsi directement les plots d'accrochage sans nécessiter une étape supplémentaire de formation de plots si les matériaux des plots et des billes sont compatibles. Dans le cas contraire, un dépôt de matériau adapté sera nécessaire pour former les plots d'accrochage. Dans le cas où le matériau fusible est non conducteur, il peut être nécessaire, avant la formation des plots d'accrochage, d'effectuer une étape de nettoyage pour éliminer les résidus de matériau fusible après décollement.

D'autres caractéristiques et avantages de la présente invention ressortiront mieux de la description qui va suivre, en référence aux figures annexées, données à titre purement illustratif et non limitatif.

### Brève description des figures

- la figure 1, déjà décrite, est une coupe schématique transversale d'une structure comportant un substrat d'interconnexion d'un type connu qui relie une puce électronique à un substrat de réception,
- la figure 2, déjà décrite, est une coupe schématique transversale d'une autre structure comportant également un substrat d'interconnexion de type connu,
- la figure 3, déjà décrite, est une coupe schématique d'une structure connue de type MCM comportant un substrat 'd'interconnexion associé à un substrat intermédiaire supplémentaire qui comporte plusieurs puces électroniques,
- les figures 4 à 9 sont des coupes schématiques illustrant la fabrication d'un substrat d'interconnexion selon un mode de mise en oeuvre de la présente invention,
- les figures 10 et 11 sont des coupes schématiques illustrant le garnissage du substrat d'interconnexion de billes de matériau fusible et son report sur un substrat de réception.

### Description de modes de mise en oeuvre de l'invention

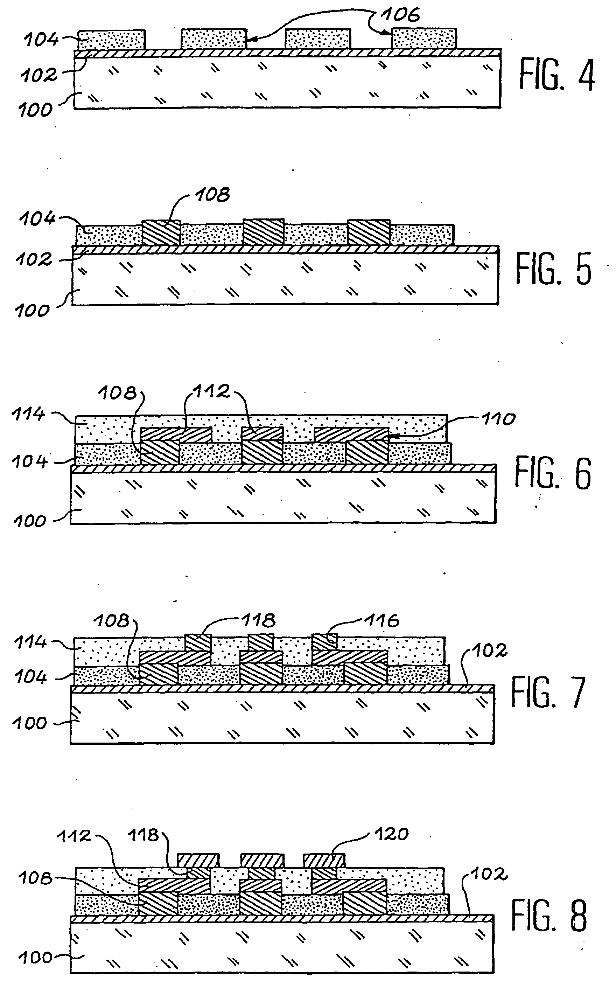

Comme le montre la figure 4, on forme sur un substrat initial 100, par exemple en silicium, une couche de matériau fusible conducteur électrique 102. Cette couche, qui forme un fond continu, est par exemple déposée par pulvérisation cathodique ou par évaporation avec une épaisseur de l'ordre de 1µm. Un matériau avantageux pour cette couche est un alliage d'étain et de plomb SnPb 60-40, pour sa faible température de fusion.

Sur la couche 102 on forme une couche de matériau diélectrique 104, par exemple de polyimide, avec une épaisseur de l'ordre de 5µm. Cette couche 104 est gravée selon des motifs dits d'ouverture pour y former des ouvertures 106 correspondant à des bornes de sortie du substrat d'interconnexion. Une étape suivante du procédé est, comme le montre la figure 5, la croissance par électrolyse de métal, par exemple du cuivre, dans les ouvertures du masque en utilisant la couche conductrice 102 comme électrode. On forme ainsi des pavés 108.

Une couche de métal 110, par exemple de cuivre, recouvrant les pavés 108 est formée par pulvérisation cathodique. Cette couche 110, d'une épaisseur de l'ordre de 5µm est ensuite gravée selon des procédés de lithographie connus, selon des motifs de piste afin de former des pistes conductrices 112 visibles à la figure 6. Les pistes conductrices 112 sont conformées de façon à se superposer, au moins en partie avec les pavés 108, afin d'être en contact électrique avec ces pavés. L'orientation et la forme des pistes sont dictées essentiellement par la disposition et le pas respectifs des bornes d'entrée et de sortie du substrat d'interconnexion. Les pistes 112 sont ensuite recouvertes avec une couche 114 de matériau diélectrique ; il s'agit, par exemple, d'une couche de polyimide avec une épaisseur de l'ordre de 5µm.

Comme le montre la figure 7, le procédé se poursuit par la gravure de la couche diélectrique 114 afin d'y pratiquer des ouvertures 116 qui se superposent au moins en partie aux pistes conductrices 112. Des pavés conducteurs 118, par exemple de cuivre, sont formés dans ces ouvertures 116.

De façon avantageuse, la couche 102, les pavés 106 et les pistes 112 forment une électrode pour la croissance par électrolyse des pavés 118.

bans le mode de réalisation décrit, des plots d'accrochage 120 sont formés respectivement sur les pavés pour obtenir la structure représentée à la figure 8. Les plots d'accrochage 120 qui forment les bornes d'entrée sont réalisés par exemple par dépôt d'une couche de TiNiAu puis par gravure de cette couche selon un motif convenable.

Dans d'autres modes de réalisation, il est possible, bien entendu, d'ajouter une ou plusieurs couches métalliques dans lesquelles on grave des pistes conductrices, et qui sont séparées par des couches diélectriques et reliées électriquement par des pavés métalliques. Il suffit dans ce cas de répéter les opérations illustrées aux figures 6 et 7.

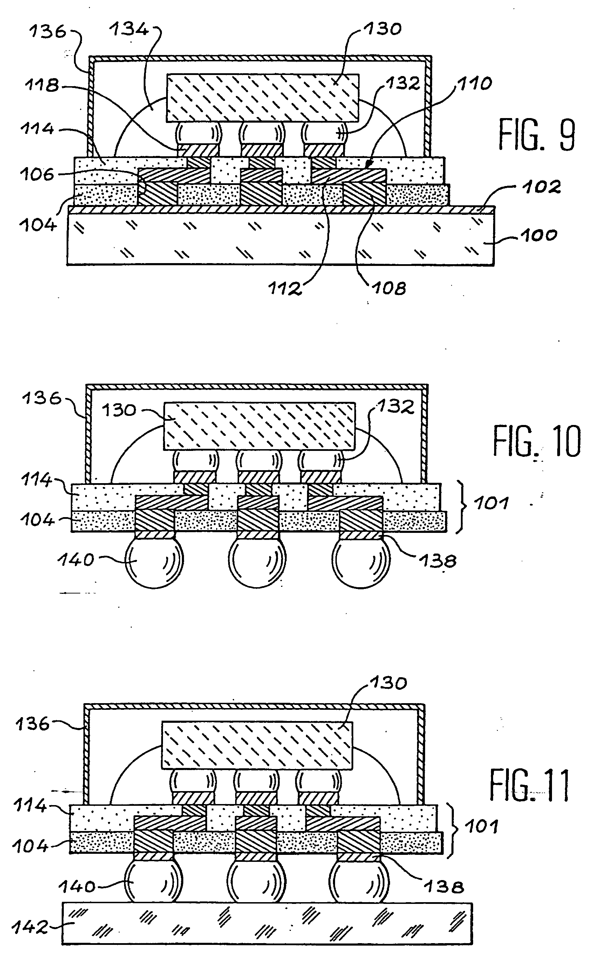

Le pas des pavés 118, et les plots d'accrochage 120 sont adaptés aux pas des entrées et sorties d'une ou plusieurs puces 130. Comme le montre la figure 9, une telle puce 130 peut être raccordée au substrat d'interconnexion au moyen de microbilles fusibles 132. Ces microbilles sont réalisées en un matériau fusible conducteur électrique présentant une température de fusion supérieure à celle de la couche 102.

Ainsi lorsque le matériau de la couche 102 est un alliage SnPb 60-40, on peut utiliser, par exemple un alliage SnPb 5-95 pour les microbilles.

De façon avantageuse, la puce 130 peut encore être solidarisée avec le substrat d'interconnexion 101 au moyen d'une résine 134 du type "Underfill" et protégée par un capot 136.

Le procédé se poursuit par la désolidarisation du substrat d'interconnexion d'avec le substrat initial 100. La désolidarisation peut être obtenue aisément en déposant la structure sur une plaque chauffante apte à chauffer la couche 102 à une température supérieure à la température de fusion du matériau qui la constitue, mais inférieure de façon préférentielle à celle des microbilles. Dans le cas où ce matériau est le SnPb 60-40 mentionné ci-dessus, la température de chauffage est de l'ordre de 200°C.

Les pavés 106 qui forment des bornes de sortie sont recouverts, par exemple, de plots d'accrochage 138, en AuNi. Ces plots 138 sont formés, par exemple, par dépôt chimique.

Le substrat d'interconnexion est ensuite éventuellement scié pour le partager en substrats d'interconnexion élémentaires, puis garni de macrobilles 140 sur les plots d'accrochage 138. Ces billes 140 sont par exemple en alliage SnPb 60-40. Pour la mise en place de ces billes, on peut se reporter par exemple au document (1), page 62.

Comme le montre la figure 11, les macrobilles servent au report du substrat d'interconnexion 101 sur un substrat de réception 142 qui est par exemple une carte de circuit imprimé ou une structure de céramique multicouche avec des pistes conductrices (non représentées). Le substrat de réception peut à cet effet être également équipé de plots d'accrochage (non représentés)

Comme indiqué ci-dessus, les billes de matériau fusible assurent non seulement une liaison électrique et mécanique entre le substrat d'interconnexion et la carte de circuit imprimé, mais réduisent également les contraintes mécaniques résultant d'une différence de dilatation entre le circuit imprimé et le substrat d'interconnexion.

### DOCUMENTS CITES

***1)*** "Ball Brid Array" Tech Search International, INC. 1994.
***2)*** "Thin Film Transfer Process for Low Cost MCM-D Fabrication" IEEE Transactions on Components Packaging, and Manufacturing Technology, Part B, vol. 18, n°1, February 1995, pp. 42 à 46.

## Revendications

1. Procédé de réalisation d'un substrat d'interconnexion permettant de connecter au moins une puce électronique sur un substrat de réception, le substrat d'interconnexion présentant une première face avec des bornes d'entrée (108) aptes à être connectés à la puce (130) et une deuxième face, opposée à la première face, présentant des bornes de sortie (138) aptes à être connectés au substrat de réception (142), le procédé comportant les étapes suivantes :
a) - formation sur un substrat (100) dit initial, d'une couche de détachement (102),
b) - formation d'une première couche de matériau diélectrique (104) et gravure de cette couche (104) pour y pratiquer des ouvertures (106) correspondant aux bornes de sortie du substrat d'interconnexion,
c) - formation de pavés de métal (108) respectivement dans les ouvertures (106), les pavés (108) formant les bornes de sortie,
d) - dépôt d'une couche de métal (110) recouvrant les pavés de métal,
e) - gravure de la couche de métal (110) pour former des pistes conductrices (112), les pistes se superposant, au moins en partie aux ouvertures (106) pratiquées dans la couche de matériau diélectrique (104, 114) située sous la couche de métal (110) formée lors de l'étape d),
f) - formation d'une couche de matériau diélectrique (114) recouvrant les pistes conductrices et gravure de cette couche (114) pour y former des ouvertures se superposant au moins en partie, aux pistes conductrices (112) formées lors de l'étape e),
g)- formation de pavés de métal dans les ouvertures pratiquées dans la couche de matériau diélectrique (114) lors de l'étape f),
h) - séparation du substrat d'interconnexion d'avec le substrat initial
charactérisé en ce que la couche de détachement est un matériau fusible, et en ce que l'étape h) de séparation est réalisée par chauffage du matériau fusible (102) à une température supérieure ou égale à sa température de fusion.

2. Procédé selon la revendication 1, **caractérisé en ce qu'**il comporte en outre entre les étapes g) et h) une étape de formation de plots d'accrochage (138) respectivement sur les pavés de métal formés lors de l'étape g), les plots d'accrochage (138) formant les bornes d'entrée.

3. Procédé selon la revendication 1, **caractérisé en ce que** pour la formation d'une couche de matériau fusible (102) on utilise un matériau conducteur électrique.

4. Procédé selon la revendication 3, **caractérisé en ce qu'**on utilise un alliage d'étain et de plomb comme matériau fusible conducteur électrique.

5. Procédé selon la revendication 3, **caractérisé en ce que** lors de l'étape c) les pavés sont formés par électrolyse, en utilisant la couche de matériau fusible (102) comme électrode.

6. Procédé selon la revendication 3, **caractérisé en ce que** lors de l'étape g) les pavés (118) de métal sont formés par électrolyse en utilisant la couche de matériau fusible (102) des pavés et les pistes conductrices (112) comme électrodes.

7. Procédé selon la revendication 1, **caractérisé en ce que** les étapes d), e), f) et g) sont répétées plusieurs fois.

8. Procédé selon la revendication 1, **caractérisé en ce que** ladite au moins une puce électronique (130) est connectée sur le substrat d'interconnexion avant l'étape h).

9. Procédé selon la revendication 8, **caractérisé en ce que** la puce (130) est en outre fixée sur le substrat au moyen d'une résine (134).

10. Procédé selon la revendication 1, **caractérisé en ce qu'**il comporte en outre une étape de découpage du substrat d'interconnexion.

11. Procédé selon la revendication 1, **caractérisé en ce qu'**il comporte en outre, après l'étape h), la mise en place sur les bornes de sortie (138) de billes (140) de matériau fusible soit directement, soit par l'intermédiaire de plots d'accrochage (138).

12. Procédé selon la revendication 1, **caractérisé en ce qu'**on utilise du polyimide comme matériau diélectrique.

13. Procédé selon la revendication 1, **caractérisé en ce qu'**on utilise du cuivre pour former les pavés de métal dans les ouvertures et pour former les pistes conductrices.

## Claims

1. Process for making an interconnection substrate to connect at least one electronic chip onto a reception substrate, the interconnection substrate having a first side with input terminals (108) capable of being connected to the chip (130), and a second side, opposite the first side, with output terminals (138) capable of being connected to the reception substrate (142), said process including the following steps:
a) forming a detachment layer (102) on a so-called initial substrate (100),
b) forming a first layer (104) of dielectric material and engraving this layer (104) to make openings (106) corresponding to the interconnection substrate output terminals,
c) forming metal blocks (108) respectively in the openings (106), the blocks (108) forming the output terminals,
d) depositing a metal layer (110) covering the metal blocks,
e) engraving the metal layer (110) to form conducting tracks (112), the tracks at least partially superimposing the openings (106) formed in the dielectric material layer (104, 114) located under the metal layer (110) formed in step d),
f) forming a dielectric material layer (114) covering the conducting tracks and engraving this layer (114) to form openings therein at least partially covering the conducting tracks (112) formed during step e),
g) forming metal blocks in the openings formed in the dielectric material layer (114) formed in step f),
h) separating the interconnection substrate from the initial substrate, **characterized in that** the detachment layer is a meltable material and the separation step h) is implemented by heating the meltable material (102) to a temperature equal to or exceeding its melting temperature.

2. Process according to claim 1, **characterized in that** it further includes, between steps g) and h), a step of forming fastening studs (138) on the metal blocks formed in step g), the fastening studs (138) forming the input terminals.

3. Process according to claim 1, **characterized in that** an electrically conducting material is used for the formation of a layer of meltable material (102).

4. Process according to claim 3, **characterized in that** a tin-lead alloy is used as the electrically conducting meltable material.

5. Process according to claim 3, **characterized in that** the blocks in step c) are formed by electrolysis, using the meltable material layer (102) as an electrode.

6. Process according to claim 3, **characterized in that** during step g) the metal blocks (118) are formed by electrolysis using the meltable material layer (102) in the blocks and conducting tracks as electrodes.

7. Process according to claim 1, **characterized in that** steps d), e), f) and g) are repeated several times.

8. Process according to claim 1, **characterized in that** said at least one electronic chip (130) is connected to the interconnection substrate prior to step h).

9. Process according to claim 8, **characterized in that** the chip (130) is further fixed to the substrate by means of a resin (134).

10. Process according to claim 1, **characterized in that** it further comprises a step of cutting of the interconnection substrate.

11. Process according to claim 1, **characterized in that** it further comprises, after step h), placing meltable material balls (140) on output terminals (138), either directly or by means of fastening studs (138).

12. Process according to claim 1, **characterized in that** polyimide is used as the dielectric material.

13. Process according to claim 1, **characterized in that** copper is used to form the metal blocks in the openings and to form the conducting tracks.

## Patentansprüche

1. Verfahren zur Herstellung eines Verdrahtungssubstrats zur Verbindung wenigstens eines elektronischen Chips mit einem Träger, wobei das Verdrahtungssubstrat eine erste Seite mit Eingangsanschlüssen (108) aufweist, die mit dem Chip (130) verbunden werden können, und eine der ersten Seite entgegengesetzte zweite Seite, die Ausgangsanschlüsse (138) aufweist, die mit dem Träger (142) verbunden werden können, wobei das Verfahren die folgenden Schritte umfasst:
a) - Bilden einer Trennschicht (102) auf einem Anfangssubstrat genannten Substrat (100),
b) - Bilden einer ersten dielektrischen Materialschicht (104) und Ätzen dieser Schicht (104), um in ihr Öffnungen (106) herzustellen, entsprechend den Ausgangsanschlüssen des Verdrahtungssubstrats,
c) - Bilden von Metallblöcken (108) jeweils in den Öffnungen (106), wobei diese Metallblöcke (108) die Ausgangsanschlüsse sind,
d) - Abscheiden einer die Metallblöcke bedeckenden Metallschicht (110),
e) - Ätzen der Metallschicht (110), um Leiterbahnen (112) zu bilden, wobei diese Leiterbahnen wenigstens teilweise die Öffnungen (106) überdecken, hergestellt in der dielektrischen Materialschicht (104, 114), die sich unter der in Schritt **d)** gebildeten Metallschicht (110) befindet,
f) - Bilden einer die Leiterbahnen bedeckenden dielektrischen Materialschicht (114) und Ätzen dieser Schicht (114), um in ihr Öffnungen herzustellen, die sich wenigstens teilweise über den in dem Schritt e) gebildeten Leiterbahnen (112) befinden,
g) - Bilden von Metallblöcken (118) in den in Schritt f) in der dielektrischen Materialschicht (114) hergestellten Öffnungen,
h) - Trennung des Verdrahtungssubstrats von dem Anfangssubstrat,
**dadurch gekennzeichnet,**
**dass** die Trennschicht aus einem schmelzbaren Material ist und dass der Trennschritt h) darin besteht, das schmelzbare Material (102) auf eine Temperatur zu erwärmen, die gleich ist oder höher als seine Schmelztemperatur.

2. Verfahren nach Anspruch 1, **dadurch gekennzeichnet, dass** es außerdem zwischen den Schritten g) und h) einen Schritt zur Bildung von Befestigungselementen (138) jeweils auf den in Schritt g) gebildeten Metallblöcken umfasst, wobei die Befestigungselemente (138) Eingangsanschlüsse bilden.

3. Verfahren nach Anspruch 1, **dadurch gekennzeichnet, dass** man zur Bildung einer Schicht aus schmelzbarem Material (102) ein elektrisch leitfähiges Material verwendet.

4. Verfahren nach Anspruch 3, **dadurch gekennzeichnet, dass** man als elektrisch leitfähiges schmelzbares Material eine Zinn- und Blei-Legierung verwendet.

5. Verfahren nach Anspruch 3, **dadurch gekennzeichnet, dass** man die Metallblöcke in Schritt c) durch Elektrolyse bildet, indem man die Schicht aus schmelzbarem Material (102) als Elektrode benutzt.

6. Verfahren nach Anspruch 3, **dadurch gekennzeichnet, dass** man die Metallblöcke (118) in Schritt g) durch Elektrolyse bildet, indem man die Schicht aus schmelzbarem Material (102), Blöcke (108) und die Leiterbahnen (112) als Elektroden benutzt.

7. Verfahren nach Anspruch 1, **dadurch gekennzeichnet, dass** die Schritte d), e), f) und g) mehrmals wiederholt werden.

8. Verfahren nach Anspruch 1, **dadurch gekennzeichnet, dass** der wenigstens eine genannte elektronische Chip (130) vor dem Schritt h) mit dem Verdrahtungssubstrat verbunden wird.

9. Verfahren nach Anspruch 8, **dadurch gekennzeichnet, dass** der Chip (130) außerdem an dem Substrat mittels eines Harzes (134) befestigt wird.

10. Verfahren nach Anspruch 1, **dadurch gekennzeichnet, dass** es außerdem einen Zuschneidschritt des Verdrahtungssubstrats umfasst.

11. Verfahren nach Anspruch 1, **dadurch gekennzeichnet, dass** es außerdem nach dem Schritt h) das Anbringen von Kugeln (140) aus schmelzbarem Material auf den Ausgangsanschlüssen (108) umfasst, entweder direkt oder mittels Befestigungselementen (138).

12. Verfahren nach Anspruch 1, **dadurch gekennzeichnet, dass** man als dielektrisches Material Polyimid verwendet.

13. Verfahren nach Anspruch 1, **dadurch gekennzeichnet, dass** man Kupfer verwendet, um die Metallblöcke in den Öffnungen zu bilden und um die Leiterbahnen zu bilden.
